(19) Europäisches Patentamt
European Patent Office
Office européen des brevets

(11) **EP 4 539 151 A1**

(12) **EUROPEAN PATENT APPLICATION**
published in accordance with Art. 153(4) EPC

(43) Date of publication:
**16.04.2025  Bulletin 2025/16**

(21) Application number: 23839938.0

(22) Date of filing: **11.07.2023**

(51) International Patent Classification (IPC):
*H01M 4/139* (2010.01)    *H01M 4/13* (2010.01)
*H01M 4/62* (2006.01)     *G06T 17/20* (2006.01)
*G06T 7/60* (2017.01)

(52) Cooperative Patent Classification (CPC):
**G06T 7/60; G06T 17/20; H01M 4/13; H01M 4/139;
H01M 4/62;** Y02E 60/10

(86) International application number:
**PCT/KR2023/009888**

(87) International publication number:
**WO 2024/014846 (18.01.2024 Gazette 2024/03)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **12.07.2022  KR 20220085868**

(71) Applicant: **LG Energy Solution, Ltd.
Seoul 07335 (KR)**

(72) Inventors:
• **PARK, Joo Nam**
  **Daejeon 34122 (KR)**
• **KO, Yo Han**
  **Daejeon 34122 (KR)**
• **KIM, Hyeong Seok**
  **Daejeon 34122 (KR)**

(74) Representative: **Plasseraud IP
104 Rue de Richelieu
CS92104
75080 Paris Cedex 02 (FR)**

(54) **METHOD FOR FORMING THREE-DIMENSIONAL ELECTRODE STRUCTURE**

(57)    The present application can provide a method of forming an analytical three-dimensional electrode structure, a hardware device in which the method is stored, and a system for forming the analytical three-dimensional electrode structure. The present application can provide a method capable of effectively forming an electrode structure with an excellent matching degree to an actual electrode. In addition, the present application can provide a method capable of forming an electrode structure in which the type and volume characteristics of the actual electrode are appropriately reflected. The present application can provide a method capable of forming such an electrode structure simply, quickly, and efficiently.

Fig. 1

EP 4 539 151 A1

## Description

### Technical Field

This application claims the benefit of priority based on Korean Patent Application No. 10-2022-0085868 dated July 12, 2022, the disclosure of which is incorporated herein by reference in its entirety.

The present application relates to a method of forming a three-dimensional electrode structure, a hardware device in which the method is stored, and a system for forming the analytical three-dimensional electrode structure.

### Background Art

A digital twin technology is a technology that predicts results by creating a twin of a real object in a virtual space within a computer and simulating situations capable of occurring from reality.

Such a digital twin technology can be applied in various fields.

For example, the digital twin technology can be utilized in research and development of secondary batteries.

The secondary battery is a device that can generate electricity, if necessary, after electrical energy is converted into in the form of chemical energy to be stored, which can be charged and discharged. With the expansion of the electric vehicle market, there is a demand for the development of secondary batteries having excellent stability and capable of realizing a high energy density, and the digital twin technology can be applied in the development of such secondary batteries.

For example, Patent Document 1 discloses a method of modeling a three-dimensional electrode structure through the digital twin technology.

In the method disclosed in Patent Document 1, an electrode structure is formed by combining so-called three-dimensional formation technology (3D Formation) and three-dimensional reconstruction technology (3D Reconstruction).

However, in the above method, the electrode structure is formed in the same manner regardless of the type of electrode, whereby there are problems that the matching degree to the actual electrode is lowered, the structure reflecting the volume characteristics of the electrode cannot be formed, and the verification technology of the formed electrode structure has low systematicity.

[Prior Art Documents]

[Patent Document 1]
(Patent Document 1) Korean Laid-Open Patent Publication No. 10-2021-0063821

### Disclosure

### Technical Problem

The present application can provide a method of forming an analytical three-dimensional electrode structure, a hardware device in which the method is stored, and a system for forming the analytical three-dimensional electrode structure.

The present application can provide a method capable of effectively forming an electrode structure with an excellent matching degree to an actual electrode. In addition, the present application can provide a method capable of forming an electrode structure in which the type and volume characteristics of the actual electrode are appropriately reflected. The present application can provide a method capable of forming such an electrode structure simply, quickly, and efficiently.

### Technical Solution

The present application relates to a method of forming a three-dimensional electrode structure.

The method may comprise steps of setting a sample structure volume; forming an initial electrode structure having the formed sample structure volume; and verifying the initial electrode structure.

The method may further comprise a step of providing design parameters of an electrode sample to set the sample structure volume.

Here, the design parameter may be one or more selected from the group consisting of a type of an electrode material, a content of an electrode material, a shape of an electrode material, mechanical properties of an electrode material, an electrode loading level, an electrode density, and a dispersion rate of the material along an electrode thickness direction.

The step of setting a sample structure volume may comprise steps of: (1) forming a sample electrode structure using the design parameters; and (2) setting the sample electrode structure volume through downsizing of the sample electrode structure.

Here, the step (2) may comprise a step of reducing the volume of the sample electrode structure, and simultaneously confirming structural parameters of each electrode structure whose volume has been reduced.

Here, the structural parameter may be one or more selected from the group consisting of tortuosity, specific surface area, and a volume ratio of a conductive material.

The minimum volume, in which an error ratio of the structural parameter of the electrode structure whose volume has been reduced in the step (2) to the structural parameter of the sample electrode structure is 10% or less, may be designated as the sample structure volume.

Here, the volume reduction of the electrode structure may be performed so that the volume is 0.1 to 0.5 times the volume of the electrode structure before the volume reduction.

When forming the sample electrode structure, electrode materials may be formed in the order of a largest volume ratio in the electrode.

Here, when forming the initial electrode structure, electrode materials may be formed in the order of a largest volume ratio in the electrode.

In the step of verifying the initial electrode structure, a step of comparing the structural parameters of the initial electrode structure and the structural parameters of an electrode sample may be performed.

The structural parameter may be one or more selected from the group consisting of void tortuosity, an interface area between an active material and a void, and effective electrical conductivity of a conductive material.

Here, when the absolute value of the error ratio between the structural parameters is 5% or more, a step of correcting the electrode structure may further be performed.

Here, when the error ratio for the effective electrical conductivity of the conductive material, which is the structural parameter, is 5% or more, a contact angle between an active material and a conductive material, or the active material and a binder among the electrode materials may be corrected in the 90-degree direction, and when the error ratio is -5% or less, the correction of the contact angle in a direction away from 90 degrees may be performed.

Here, when the error ratio for the void tortuosity, which is the structural parameter, is 5% or more, the contact angle between the active material and the conductive material, or the active material and the binder among the electrode materials may be reduced, and when the error ratio is -5% or less, the correction in a direction increasing the contact angle may be performed.

Here, when the error ratio for the interface area between the active material and the void, which is the structural parameter, is 5% or more, the contact angle between the active material and the conductive material, or the active material and the binder among the electrode materials may be reduced, and when the error ratio is -5% or less, the contact angle may be increased.

The present application also relates to a hardware device in which the method is stored.

## Advantageous Effects

The present application can provide a method of forming an analytical three-dimensional electrode structure, a hardware device in which the method is stored, and a system for forming the analytical three-dimensional electrode structure. The present application can provide a method capable of effectively forming an electrode structure with an excellent matching degree to an actual electrode. In addition, the present application can provide a method capable of forming an electrode structure in which the type and volume characteristics of the actual electrode are appropriately reflected. The present application can provide a method capable of forming such an electrode structure simply, quickly, and efficiently.

## Description of Drawings

Fig. 1 is a flowchart showing processes of the method of the present application.

Fig. 2 is a schematic diagram showing a process of obtaining a sample structure volume.

Fig. 3 is a view showing an order of forming an electrode structure.

Fig. 4 is a diagram for explaining a process of obtaining effective electrical conductivity.

Fig. 5 is a schematic diagram showing a process of correcting an electrode structure through contact angles.

## Mode for Invention

The present application relates to a method of forming a three-dimensional electrode structure, and specifically, relates to a method of forming an analytical three-dimensional electrode structure through a digital twin technology.

The analytical three-dimensional electrode structure is a twin of an actual electrode (electrode sample) implemented through the digital twin technology, which may mean an electrode structure to be applicable to various simulations.

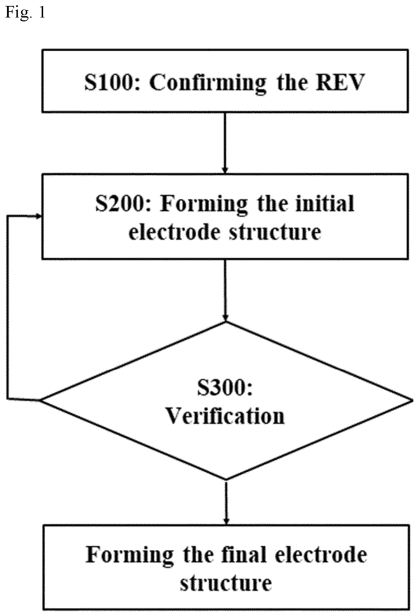

Fig. 1 is a flowchart showing a method of forming an electrode structure according to an example of the present application.

As shown in Fig. 1, the method of the present application may comprise at least steps of: setting a sample structure volume (REV: representative elementary volume) (S100); forming an electrode structure (S200); and verifying the electrode structure (S300).

The term sample structure volume (REV) means the minimum volume of the electrode structure that can provide measurement results capable of representing the actual electrode. The sample structure volume may also mean the volume of the electrode structure capable of calculating the same calculated value as the actual electrode with minimal calculation.

The present application can form an electrode structure having a high matching degree to the actual electrode and effectively reflecting the volume characteristics of the actual electrode by first setting the sample structure volume and forming the electrode structure according to the set results, and then going through a verification step.

The sample structure volume may be set based on design parameters. The design parameters are information about the electrode applied to form the electrode structure, which mean information about the actual electrode (hereinafter, referred to as the electrode sample).

Therefore, the method of the present application may further comprise a step of providing the design parameters or obtaining the design parameters as a pre-step of the step of setting the sample structure volume.

The design parameters may be exemplified by one or more selected from the group consisting of a type of an electrode material, a content of an electrode material, a shape of an electrode material, mechanical properties of an electrode material, an electrode loading level, an electrode density, and a dispersion rate of the material along an electrode thickness direction.

In the information on the type of the electrode material, for example, information on a type of an electrode active material such as a positive electrode active material or a negative electrode active material, a type of a conductive material, a type of a binder, a type of an electrolyte, a type of a current collector, and/or a type of a separator, and the like may be included, as the materials forming the electrode.

In the information on the content of the electrode material, information on the content of the electrode active material, conductive material, binder and/or electrolyte, and the like in the electrode, or the ratio of the contents to each other may be included.

In the information on the shape of the electrode material, for example, when the material constituting the electrode active material, conductive material, binder and/or electrolyte, and the like is in the form of particles, information on the shape or particle size distribution, and the like of the relevant particles may be included, as the information on the shape of the electrode material.

In the information on the mechanical properties of the electrode material, information on a true density or a deformation ratio may be included; in the information on the electrode loading level, information on the amount of the electrode active material (negative electrode active material or positive electrode active material) per unit area of the electrode, and the like may be included; and in the information on the dispersion rate of the electrode material along the electrode thickness direction, information on the distribution of the electrode material (active material, binder, conductive material and/or electrolyte, etc.) along the electrode thickness direction, and the like may be included.

The method of obtaining or providing the design parameters is not particularly limited. Such a parameter may be obtained through the method according to the three-dimensional formation technology (3D Formation), the method according to the three-dimensional reconstruction technology (3D Reconstruction), or the method combining both methods.

For example, the design parameters may be provided through a method that a user inputs related information in consideration of design values, and the like, a method of retrieving relevant information from a database built for electrode samples and/or an image analysis method. The image analysis method is a method of obtaining design parameters through image analysis of electrode samples, and such a method is known. For example, in the above method, images obtained by a high-resolution nanoscale 3D X-ray microscope, FIB-SEM (Focused Ion Beam-Scanning Electron Microscope) and/or EDX (Energy Dispersed X-ray Spectroscopy) may be analyzed.

In the digital twin technology, the information necessary to form the initial structure and the method of obtaining the information are known, where in the present application, the sample electrode structure for setting the sample structure volume may be formed through such a known method.

The step of setting a sample structure volume may comprise steps of (1) forming a sample electrode structure using at least one of the design parameters, and (2) setting the sample electrode structure volume through downsizing of the sample electrode structure.

In the step (1), the sample electrode structure may be formed by a method of inputting the design parameters into an interface for implementing a digital twin to implement the electrode structure three-dimensionally.

In the digital twin technical field, the software or hardware capable of implementing the electrode structure is known, and in the present application, the electrode structure may be implemented using such a known software and/or hardware.

In the step (1), the sample electrode structure is formed to have a predetermined initial volume which is arbitrarily set.

In the step (2), a process of obtaining the sample electrode structure volume is performed through downsizing of the sample electrode structure formed to have the initial volume.

The step (2) may comprise a step of reducing the volume of the sample electrode structure, and simultaneously confirming structural parameters of each electrode structure whose volume has been reduced.

The above step is a process of repeatedly extracting smaller-sized electrode structures from the sample electrode structure, calculating structural parameter values for the extracted electrode structures, and comparing them to obtain the volume (sample structure volume) capable of calculating the same result value as the actual electrode with minimal calculations.

The structural parameter may be exemplified by tortuosity, specific surface area, and a volume ratio, and the like of the conductive material in the electrode, but is not limited thereto.

In the step (2), the step of reducing the volume of the sample electrode structure, and simultaneously confirming structural parameters of each electrode structure whose volume has been reduced may proceed until the structural parameter shows an error ratio of 5% or more relative to the initial value.

Here, the initial value of the structural parameter is the value of the structural parameter for the sample electrode structure. That is, the structural parameter of the electrode structure maintains an approximately constant level in the process of decreasing the volume of the electrode structure, but when the volume of the electrode structure becomes smaller than the sample structure volume, it indicates an error above a certain level with respect to the initial value. Therefore, the minimum volume that the error with respect to the initial value of the structural parameter is within a certain level may be designated as the sample structure volume.

Specifically, the sample structure volume may be designated as the minimum volume that the structural parameter exhibits an error ratio of 10% or less relative to the initial value. In one example, the sample structure volume may be designated as the minimum volume that the structural parameter shows an error ratio of 9% or less, 8% or less, 7% or less, 6% or less, or 5% or less, relative to the initial value. The lower limit of the error ratio applied to the minimum volume designation is not particularly limited, and in one example, the error ratio may also be 0% or more, 1% or more, 2% or more, 3% or more, 4% or more, or 5% or more or so. In one example, the sample structure volume may be the minimum volume that at least one of the tortuosity, specific surface area, and volume ratio of the conductive material, which are the structural parameters, represents an error ratio within the range relative to the initial value, or may be the minimum volume of the electrode structure that all the tortuosity, specific surface area, and volume ratio of the conductive material, which are the structural parameters, represent an error ratio within the range.

Here, the error ratio is the absolute value of ΔP to be calculated by Equation 1 below.

[Equation 1]

$$\Delta P = 100 \times (Pf - Pi)/Pi$$

In Equation 1, Pi is the initial value of the structural parameter (e.g., the initial value of the tortuosity, the specific surface area, or the volume ratio of the conductive material), and Pf is the structural parameter of the electrode structure with the reduced volume (e.g., the tortuosity, the specific surface area, or the volume ratio of the conductive material in the electrode structure with the reduced volume).

The volume (initial volume) of the sample electrode structure set in the above process is not particularly limited, where an appropriate volume may be designated considering the volume of the electrode sample. For example, the volume of the sample electrode structure may be a volume or so having an arbitrary thickness while being 400 μm or so in both width and length. The thickness of the structure may be designated as an appropriate value considering the size of the electrode as actually applied, or the efficiency of the method of the present application, and the like.

In addition, the method of reducing the volume (initial volume) of the sample electrode structure set in the above process is not particularly limited, and the volume may be stepwise reduced at a constant rate with respect to the initial volume. For example, the volume reduction may be performed so that the volume of the electrode structure after reduction is approximately 0.1 to 0.5 times or so the volume of the electrode structure before reduction. In another example, the volume ratio may be 0.15 times or more, 0.2 times or more, or 0.25 times or more or so, or may also be 0.45 times or less, 0.4 times or less, 0.35 times or less, 0.3 times or less, or 0.25 times or less or so.

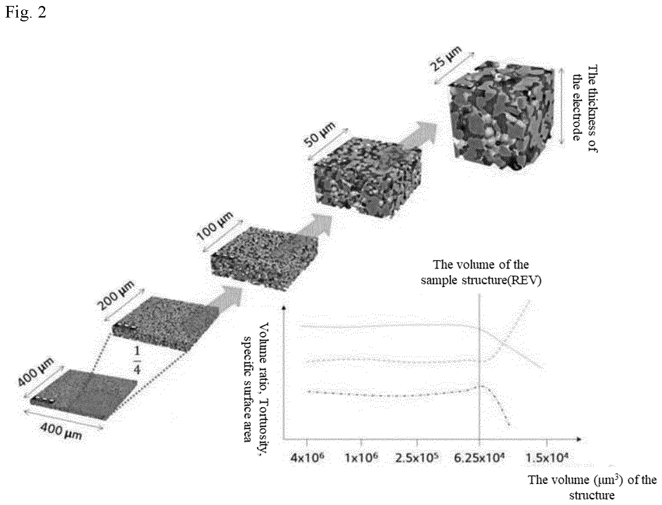

The above process is explained with reference to the example in Fig. 2 as follows.

The leftmost electrode structure in Fig. 2 is a sample electrode structure implemented by the digital twin technology, which is an electrode structure having the initial volume as arbitrarily set (in the case of Fig. 2, volume of 400μm×400μm×electrode thickness μm).

For implementation of the sample electrode structure, the electrode material is depicted three-dimensionally in a virtual space according to the design parameter information. In the present application, electrode materials in this process can be depicted three-dimensionally in a virtual space in the order of the largest volume occupied in the electrode. Depending on the type of electrode, there is a difference in the type of material forming the electrode, and there is also a difference in the ratio of the volume occupied by each electrode material in each electrode. Conventionally, the electrode structure was implemented by depicting the electrode materials in an arbitrary order without considering these differences, but in the present application, the electrode materials can be depicted in the order of the largest volume occupied in the electrode.

According to this method, the order of implementing the electrode structures varies depending on the type of electrode. For example, if the electrode to be implemented is an electrode for a lithium-ion battery/lithium-sulfur battery, the electrode structure is formed by a method of first forming an electrode active material, and then forming a conductive material and a binder (CASE 1); in the case of an electrode for an all-solid-state battery, the electrode structure is formed in the order of an electrode active material, a solid electrolyte, and a conductive material/a binder (CASE 2); and in the case of an electrode for a lithium-air battery, the electrode structure is formed in the order of a void layer, catalyst particles, and a conductive material/a binder (CASE 3).

In this way, by forming the electrode structure in a manner that depending on the volume ratio of the electrode material in the electrode, the electrode materials are formed in the order of the large ratio, it is possible to minimize the ratio of the error with the measured value for the actual electrode.

In the downsizing, as shown in Fig. 2, the structures with a specific size smaller than the sample electrode structure are repeatedly extracted. In Fig. 2, the structures are extracted while repeatedly reducing the horizontal and vertical lengths (400μm) of the sample electrode structure by 1/4.

To obtain the sample structure volume, structural parameter values are calculated for the respective electrode structures repeatedly extracted through the above process.

The structural parameters are parameters related to the performance of the battery that can be derived from the electrode structure, and an example thereof includes the tortuosity, the specific surface area and/or the volume ratio of the conductive material, and the like, as described above.

The methods of calculating the structural parameters in the electrode structure are known. For example, the volume ratio (volume fraction, $\varepsilon$) and connection tortuosity ($\tau$) of the conductive material can be calculated according to the method of calculating the effective electrical conductivity ($\sigma_{eff}$) of the electrode structure. The effective electrical conductivity is a charge conduction characteristic, which is actually expressible in the electrode, as calculated in consideration of the volume ratio (volume fraction, $\varepsilon$) and tortuosity ($\tau$) of the conductive material, which is calculated by the equation $\sigma_{eff} = (\varepsilon/\tau^2) \times \sigma$ (in the above equation, $\sigma_{eff}$ is the effective electrical conductivity, $\varepsilon$ is the volume ratio of the conductive material, $\tau$ is the tortuosity, and $\sigma$ is the intrinsic conductivity of the conductive material), so that the volume ratio and tortuosity can be confirmed through the calculation of the effective electrical conductivity.

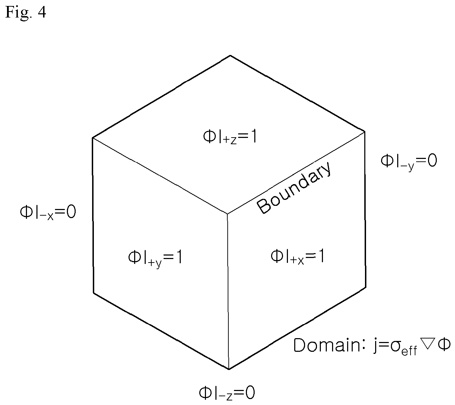

The effective electrical conductivity can be calculated, for example, by a method of applying a continuity equation of Ohm's law as a governing equation, and applying Dirichlet boundary condition under the assumption that the voltage difference of 1V between the sides facing each other concentrically remains constant, as exemplarily shown in Fig. 4.

The volume ratio and connection tortuosity can also be calculated by a method of quantifying the number and shape of voxels, which are the smallest units constituting the structure, as another method.

In addition, the specific surface area as the structural parameter is a surface area of an electrode material per volume of the material, or a value obtained by dividing the interface area between heterogeneous materials by the volume of the electrode, and such a parameter can also be calculated by a method of quantifying the number and/or shape of the voxels.

In the software known to be capable of implementing the digital twin technology, there is an algorithm that can confirm the parameters through quantification of the number or shape of voxels as described above, and in the present application, the parameters and the like can be confirmed through such an algorithm.

The sample structure volume may be designated as the volume just before the time point when the error ratio for the initial value of the relevant structural parameter starts to be above a certain level while repeating the process of confirming the structural parameter, as described above. The graphs shown at the bottom right of Fig. 2 are the results of determining the sample structure volume through such a process, and in the example of Fig. 2, the sample structure volume is specified to be approximately $6.25 \times 10^4$ μm$^3$ or so.

In the method of the present application, the sample structure volume is determined by the above method, and then a step of forming an electrode structure (hereinafter, initial electrode structure) having the relevant sample structure volume is performed.

In the method of performing the step of forming the initial electrode structure, the electrode structure may be formed substantially in the same method as the method of forming the sample electrode structure in the step (1), except that it is formed to have the sample structure volume.

By forming the electrode structure having the sample structure volume based on the provided design parameters, this can be used as an initial electrode structure.

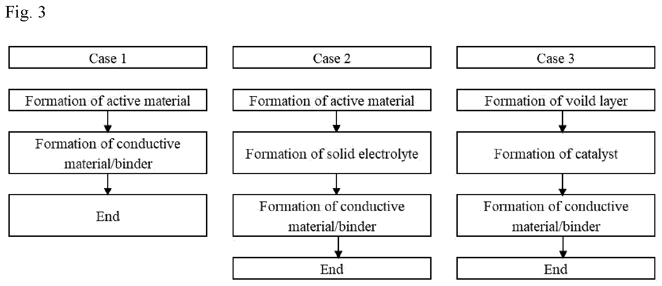

In this process, like the formation of the sample electrode structure, the electrode structures can be formed by three-dimensionally depicting the electrode materials in a virtual space in the order of the largest volume occupied in the electrode, and through this, it is possible to secure the advantages as described above. Therefore, for example, if the electrode to be implemented is an electrode for a lithium-ion battery/lithium-sulfur battery, the electrode structure may be formed by a method of first forming an electrode active material, and then forming a conductive material and a binder; in the case of an electrode for an all-solid-state battery, the electrode structure may be formed in the order of an electrode active material, a solid electrolyte, and a conductive material/a binder; and in the case of an electrode for a lithium-air battery, the electrode structure may be formed in the order of a void layer, catalyst particles, and a conductive material/a binder, as shown in Fig. 3.

In the method of the present application, after the initial electrode structure is formed, the step of verifying the initial electrode structure may be performed.

Such a step may comprise a step of comparing the structural parameters of the initial electrode structure with the structural parameters of the electrode sample (actual electrode).

The structural parameters confirmed in the above process may be any one, two, or all three of the void tortuosity, the interface area between the active material and the void, and the effective electrical conductivity of the conductive material.

Here, the void tortuosity is a concept included in the tortuosity among the structural parameters confirmed for the electrode structures repeatedly extracted to obtain the sample structure volume, and the interface area between the active material and the void is a concept included in the specific surface area among the structural parameters confirmed for the electrode structures repeatedly extracted to obtain the sample structure volume.

The void tortuosity and the interface area between the active material and the void can be obtained by a known method, and can each be obtained according to the methods of obtaining the tortuosity and the specific surface area among the structural parameters confirmed for the electrode structures repeatedly extracted to obtain the sample structure volume.

The effective electrical conductivity can be calculated, for example, by a method of applying a continuity equation of Ohm's law as a governing equation, and applying Dirichlet boundary condition under the assumption that the voltage difference of 1V between the sides facing each other concentrically remains constant, as exemplarily shown in Fig. 4.

The methods of obtaining the structural parameters in the initial electrode structure implemented with the digital twin technology and the actual electrode sample are known, and such known methods can be applied in the present application.

If the error ratio between the structural parameters of the initial electrode structure and the structural parameters of the electrode sample (actual electrode) is below a certain level, the relevant initial structure may be designated as the final electrode structure.

Here, the error ratio is $\Delta V$ to be calculated by Equation 2 below.

[Equation 2]

$$\Delta V = 100 \times (V_R - V_I)/V_R$$

In Equation 2, $V_I$ is the structural parameter of the initial electrode structure (e.g., the effective electrical conductivity, the void tortuosity, or the interface area between the active material and the void), and $V_R$ is the structural parameter of the electrode sample (actual electrode) (e.g., the effective electrical conductivity, the void tortuosity, or the interface area between the active material and the void).

The process may be performed until the error ratio is, for example, within the range of about -5% to 5% or so, or within the range of -3% to 3%. That is, if the error ratio between the structural parameters of the initial electrode structure and the structural parameters of the electrode sample (actual electrode) is within the range of -3% to 3%, or within the range of - 5% to 5%, the initial electrode structure can be designated as the final electrode structure.

For example, if at least one of the effective electrical conductivity, the void tortuosity, and the interface area between the active material and the void, which are the structural parameters, exhibits an error ratio within the above range, the relevant initial structure may be designated as the final structure, and in another example, the initial electrode structure in which all the effective electrical conductivity, void tortuosity, and interface area between the active material and the void, which are the structural parameters, exhibit error ratios within the above range may be designated as the final electrode structure.

If at least one of, two or more of, or all the effective electrical conductivity, void tortuosity, and interface area between the active material and the void, which are the structural parameters, exhibit error ratios exceeding the above-described range, the correction step of the electrode structure may proceed.

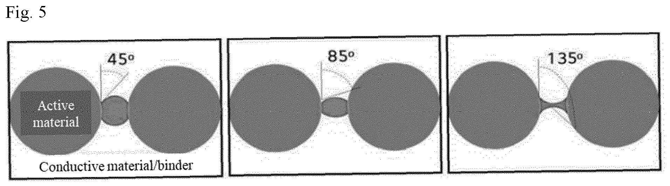

Such a correction step of the electrode structure may be performed by a method of correcting the connection shape between materials in the electrode structure and the shapes of the conductive material and the binder. For example, as shown in Fig. 5, the correction may be performed by a method of modifying the shapes of the conductive material and the binder so that the contact angle between the active material and the conductive material/the binder among the electrode materials is controlled.

The method of performing the correction for each structural parameter is not particularly limited.

For example, in the case of the effective electrical conductivity of the conductive material, if the error ratio confirmed by the above method is 3% or more, or 5% or more, the contact angle between the active material and the conductive material or the contact angle between the active material and the binder among the electrode materials may be corrected in the 90-degree direction, and if the error ratio is -3% or less or -5% or less, the contact angle may be corrected in a direction away from 90 degrees.

Here, the matter that the contact angle is corrected in the 90-degree direction means that the correction is performed so that the contact angle is close to 90 degrees. Therefore, if the contact angle is less than 90 degrees, the correction is performed to make the contact angle larger, and if it is more than 90 degrees, the correction is performed to make the contact angle smaller. In this instance, the degree to which the angle is corrected is not particularly limited, and for example, the correction may be performed so that the contact angle increases or decreases by 5 degrees. The method of performing the above correction using the digital twin technology is known.

Here, the matter that the contact angle is corrected in a direction away from 90 degrees means that the correction is performed so that the contact angle is away from 90 degrees. Therefore, if the contact angle is less than 90 degrees, the correction is performed to make the contact angle smaller, and if it is more than 90 degrees, the correction is performed to make the contact angle larger. In this instance, the degree to which the angle is corrected is not particularly limited, and for example, the correction may be performed so that the contact angle increases or decreases by 5 degrees. The method of performing the above correction using the digital twin technology is known.

Meanwhile, if the error ratio for the void tortuosity, which is the structural parameter in the above, is 3% or more, or 5% or more, the contact angle between the active material and the conductive material or the contact angle between the active material and the binder among the electrode materials is reduced, and if the error ratio is -3% or less, or -5% or less, the correction is performed in the direction of increasing the contact angle. In this process, the degree to which the angle is corrected is not particularly limited, and for example, the correction may be performed so that the contact angle increases or decreases by 5 degrees. The method of performing the above correction using the digital twin technology is known.

Also, in the above process, if the error ratio for the interface area between the active material and the void, which is the structural parameter, is 3% or more, or 5% or more, the contact angle between the active material and the conductive material or the contact angle between the active material and the binder among the electrode materials may be reduced, and if the error ratio is -3% or less, or -5% or less, the correction may be performed in the direction of increasing the contact angle. In this process, the degree to which the angle is corrected is not particularly limited, and for example, the correction may be performed so that the contact angle increases or decreases by 5 degrees. The method of performing the above correction using the digital twin technology is known.

If the structure verification process is performed again after going through the above correction process, and the error ratio is within the above-described certain level, the relevant structure may be set as the desired final structure.

The present application also relates to a hardware device in which the method of forming the electrode structure is stored.

In addition, the present application relates to an electrode structure forming system in which the hardware device is used.

The system may further comprise a device collecting the design parameters applied in the method of forming the electrode structure. The type of such a device is not particularly limited, which may be exemplified by a specimen manufacturing device that cuts the electrode sample to produce a plurality of specimens and/or an imaging device photographing images of the electrode sample and/or specimens, and the like.

**Claims**

1. A method of forming a three-dimensional electrode structure, comprising:

   confirming a representative elementary volume;
   forming an initial electrode structure having the representative elementary volume; and
   verifying the initial electrode structure.

2. The method according to claim 1, further comprising providing design parameters of an electrode sample to confirm the representative elementary volume.

3. The method according to claim 2, wherein the design parameter is one or more selected from the group consisting of a kind of an electrode material, an amount of an electrode material, a shape of an electrode material, a mechanical property of an electrode material, an electrode loading level, an electrode density, and a dispersion rate of the material along an electrode thickness direction.

4. The method according to claim 1, wherein the confirmation of the representative elementary volume comprises (1) forming a sample electrode structure using the design parameters; and (2) confirming the representative elementary volume by downsizing of the sample electrode structure.

5. The method according to claim 4, wherein the (2) confirmation of the representative elementary volume comprises reducing the volume of the sample electrode structure, and confirming structural parameters of each electrode structure whose volume has been reduced.

6. The method according to claim 5, wherein the structural parameter is one or more selected from the group consisting of tortuosity, specific surface area, and a volume ratio of a conductive material.

7. The method according to claim 5, wherein a minimum volume, in which an error ratio of the structural parameter of the electrode structure whose volume has been reduced in the step (2) to the structural parameter of the sample electrode structure is 10% or less, is designated as the representative elementary volume.

8. The method according to claim 5, wherein the volume reduction of the electrode structure is performed so that the volume is 0.1 to 0.5 times of the volume of the electrode structure before the volume reduction.

9. The method according to claim 4, wherein when forming the sample electrode structure, electrode materials are formed in the order of a largest volume ratio in the electrode.

10. The method according to claim 1, wherein when forming the initial electrode structure, electrode materials are formed in the order of a largest volume ratio in the electrode.

11. The method according to claim 1, wherein in the step of verifying the initial electrode structure, a step of comparing the structural parameters of the initial electrode structure and the structural parameters of an electrode sample is performed.

12. The method according to claim 11, wherein the structural parameter is one or more selected from the group consisting of void tortuosity, an interface area between an active material and a void, and effective electrical conductivity of a conductive material.

13. The method according to claim 12, wherein when the absolute value of the error ratio between the structural parameters is 5% or more, a step of correcting the electrode structure is further performed.

14. The method according to claim 13, wherein,

when the error ratio for the effective electrical conductivity of the conductive material, which is the structural parameter, is 5% or more, a contact angle between an active material and a conductive material, or a contact angle between the active material and a binder among the electrode materials is corrected so as to be closer to 90 degrees, and, when the error ratio is -5% or less, the contact angle between the active material and the conductive material, or the contact angle between the active material and the binder among the electrode materials is corrected in a direction away from 90 degrees.

15. The method according to claim 13, wherein,

when the error ratio for the void tortuosity, which is the structural parameter, is 5% or more, a contact angle between an active material and a conductive material, or a contact angle between the active material and a binder among the electrode materials is reduced, and, when the error ratio is -5% or less, the contact angle between the active material and the conductive material, or the contact angle between the active material and the binder among the electrode materials is increased.

16. The method according to claim 14, wherein,

when the error ratio for the interface area between the active material and the void, which is the structural parameter, is 5% or more, the contact angle between the active material and the conductive material, or the contact angle between the active material and the binder among the electrode materials is reduced, and, when the error ratio between the active material and the conductive material, or the contact angle between the active material and the binder among the electrode materials is -5% or less, the contact angle is increased.

17. A hardware device in which the method of any one of claims 1 to 16 is stored.

Fig. 1

```
┌─────────────────────────────────────┐
│     S100: Confirming the REV         │
└─────────────────────────────────────┘
                  │
                  ▼
┌─────────────────────────────────────┐
│     S200: Forming the initial        │
│         electrode structure          │
└─────────────────────────────────────┘
                  │
                  ▼
         S300:
       Verification
                  │
                  ▼
┌─────────────────────────────────────┐
│   Forming the final electrode        │
│            structure                 │
└─────────────────────────────────────┘
```

Fig. 2

Fig. 3

| Case 1 |
| --- |

| Formation of active material |
| --- |

↓

| Formation of conductive material/binder |
| --- |

↓

| End |
| --- |

| Case 2 |
| --- |

| Formation of active material |
| --- |

↓

| Formation of solid electrolyte |
| --- |

↓

| Formation of conductive material/binder |
| --- |

↓

| End |
| --- |

| Case 3 |
| --- |

| Formation of voild layer |
| --- |

↓

| Formation of catalyst |
| --- |

↓

| Formation of conductive material/binder |
| --- |

↓

| End |
| --- |

Fig. 4

$\Phi|_{+z}=1$

$\Phi|_{-y}=0$

Boundary

$\Phi|_{-x}=0$

$\Phi|_{+y}=1$

$\Phi|_{+x}=1$

Domain: $j=\sigma_{eff}\triangledown\Phi$

$\Phi|_{-z}=0$

Fig. 5

## INTERNATIONAL SEARCH REPORT

| | International application No. |
|---|---|
| | **PCT/KR2023/009888** |

| | |
|---|---|
| **A.** | **CLASSIFICATION OF SUBJECT MATTER** |
| | **H01M 4/139**(2010.01)i; **H01M 4/13**(2010.01)i; **H01M 4/62**(2006.01)i; **G06T 17/20**(2006.01)i; **G06T 7/60**(2006.01)i |

According to International Patent Classification (IPC) or to both national classification and IPC

| | |
|---|---|
| **B.** | **FIELDS SEARCHED** |

Minimum documentation searched (classification system followed by classification symbols)

H01M 4/139(2010.01); G01R 31/36(2006.01); G06F 119/02(2020.01); G06F 30/20(2020.01); G16C 10/00(2019.01); G16C 20/10(2019.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 3D 전극 구조체(three-dimensional electrode structure), 표본 구조체 부피(representative elementary volume), 디지털 트윈(digital twin)

| | |
|---|---|
| **C.** | **DOCUMENTS CONSIDERED TO BE RELEVANT** |

| Category* | Citation of document, with indication, where appropriate, of the relevant passages | Relevant to claim No. |
|---|---|---|
| A | TREMBACKI, B. L. et al. Volume-averaged electrochemical performance modeling of 3D interpenetrating battery electrode architectures. Journal of The Electrochemical Society. 2020, vol. 167, thesis no. 013507, pp. 1-12.<br>See abstract; and Conclusions. | 1-17 |
| A | SINGH, S. et al. Implementation of battery digital twin: approach, functionalities and benefits. Batteries. 2021, vol. 7, thesis no. 78, pp. 1-21.<br>See entire document | 1-17 |
| A | KR 10-2020-0010932 A (LG CHEM, LTD.) 31 January 2020 (2020-01-31)<br>See entire document | 1-17 |
| A | CN 114187970 A (QINGHUA UNIVERSITY) 15 March 2022 (2022-03-15)<br>See entire document | 1-17 |
| A | KR 10-2022-0014022 A (DAEGU GYEONGBUK INSTITUTE OF SCIENCE AND TECHNOLOGY) 04 February 2022 (2022-02-04)<br>See entire document | 1-17 |

| | | |
|---|---|---|
| ☐ Further documents are listed in the continuation of Box C. | ☑ | See patent family annex. |

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **24 October 2023** | **24 October 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

INTERNATIONAL SEARCH REPORT
Information on patent family members

International application No.

**PCT/KR2023/009888**

| Patent document cited in search report | | | Publication date (day/month/year) | Patent family member(s) | | | Publication date (day/month/year) |
|---|---|---|---|---|---|---|---|
| KR | 10-2020-0010932 | A | 31 January 2020 | KR | 10-2580935 | B1 | 19 September 2023 |
| CN | 114187970 | A | 15 March 2022 | WO | 2023-098715 | A1 | 08 June 2023 |
| KR | 10-2022-0014022 | A | 04 February 2022 | KR | 10-2398416 | B1 | 16 May 2022 |

Form PCT/ISA/210 (patent family annex) (July 2022)

**REFERENCES CITED IN THE DESCRIPTION**

**Patent documents cited in the description**

- KR 1020220085868

- KR 1020210063821